Europäisches Patentamt

European Patent Office

Office européen des brevets

(19)

(11) **EP 1 081 154 A2**

(12) **EUROPEAN PATENT APPLICATION**

(43) Date of publication:
    **07.03.2001 Bulletin 2001/10**

(51) Int. Cl.$^7$: **C07F 9/00, C23C 16/00**

(21) Application number: **00118263.3**

(22) Date of filing: **04.09.2000**

(84) Designated Contracting States:
    **AT BE CH CY DE DK ES FI FR GB GR IE IT LI LU
    MC NL PT SE**
    Designated Extension States:
    **AL LT LV MK RO SI**

(30) Priority: **02.09.1999 JP 24846799**

(71) Applicant:
    **INTERNATIONAL SUPERCONDUCTIVITY
    TECHNOLOGY CENTER
    Minato-ku, Tokyo (JP)**

(72) Inventors:
    • **Zama, Hideaki,
      Intern. Superconductivity Techn C.
      10-13, Shinonome 1-chome, Tokyo (JP)**
    • **Tanabe, Keiichi,
      Intern Superconductivity Techn C.
      10-13, Shinonome 1-chome, Tokyo (JP)**
    • **Morishita, Tadataka,
      Intern Superc. Techn. Center
      10-13, Shinonome 1-chome, Tokyo (JP)**

(74) Representative:
    **Beetz & Partner
    Patentanwälte
    Steinsdorfstrasse 10
    80538 München (DE)**

(54) **Materials and methods for growing complex perovskite oxide thin films**

(57)     The invention relates to BB'-type double metal alkoxide (B=B$^+$, B'=B$^{5+}$; B=B$^{3+}$, B'=B$^{5+}$; B=B$^{2+}$, B'=B$^{5+}$) materials to be used for metalorganic chemical vapor deposition of complex perovskite oxide thin films having plural metallic elements included in the B sites of a perovskite structure $ABO_3$,
wherein the BB'-type double metal alkoxides comprise the following compounds:

when B=B$^+$, B'=B$^{5+}$: $BB'(O\text{-}X)_6$ [B = Li, Na, K; B' = Nb, Ta; X = $CH_3$, $C_2H_5$, $iC_3H_7$, $tC_4H_9$],
when B=B$^{3+}$, B=B$^{5+}$: $BB'(O\text{-}X)_8$ [B = Al, Ga; B' = Nb, Ta; X = $CH_3$, $C_2H_5$, $iC_3H_7$, $tC_4H_9$], and
when B=B$^{2+}$, B'=B$^{5+}$: $B[B'(O\text{-}X)_6]_2$ [B = Mg, Ca, Sr, Ba; B' = Nb, Ta; X = $CH_3$, $C_2H_5$, $iC_3H_7$, $tC_4H_9$].

The invention further pertains to the preparation and the use of the double metal alkoxides for complex perovskite oxide thin film deposition.

**EP 1 081 154 A2**

## Description

FIELD OF THE INVENTION

The present invention relates to materials for forming complex perovskite oxides such as $A^{3+}{}_2 B^+ B^{5+} O_6$ [$A^{3+}$ = $Bi^{3+}$, $Gd^{3+}$, $La^{3+}$, etc; $B^+$ = $Li^+$, $Na^+$, $K^+$; $B^{5+}$ = Nb, Ta] and $A^{2+}{}_2 B^{3+} B^{5+} O_6$ [$A^{2+}$ = Ca, Sr, Ba; $B^{3+}$ = Al, Ga; $B^{5+}$ = Nb, Ta] or $A^{2+}{}_3 B^{2+} B^{5+}{}_2 O_9$ [$A^{2+}$ = Sr, Ba; $B^{2+}$ = Mg, Ca; $B^{5+}$ = Nb, Ta] and the like, the preparation of these materials, and methods for manufacturing thin films having controlled properties.

DESCRIPTION OF THE RELATED ART

Complex perovskite oxides are for example systems of formulae $A^{3+}{}_2 B^+ B^{5+} O_6$ [$A^{3+}$ = $Bi^{3+}$, $Gd^{3+}$, $La^{3+}$, etc; $B^+$ = $Li^+$, $Na^+$, $K^+$; $B^{5+}$ = Nb, Ta] $A^{2+}{}_2 B^{3+} B^{5+} O_6$ [$A^{2+}$ = Ca, Sr, Ba; $B^{3+}$ = Al, Ga; $B^{5+}$ = Nb, Ta] or $A^{2+}{}_3 B^{2+} B^{5+}{}_2 O_9$ [$A^{2+}$ = Sr, Ba; $B^{2+}$ = Mg, Ca; $B^{5+}$ = Nb, Ta] and the like.

Complex perovskite oxides are known for having the following featuers:

(1) They have advantageous microwave dielectric characteristics (in the 8 GHz band, relative dielectric constant 20-30, Q value 1000-40000, resonant frequency temperature coefficient $< \pm 100$ ppm/°C) (Shunichiro Kawashima, "Introduction: The trend of research and development on microwave dielectric material", Electronics-Ceramics, Sep. 1993, pp. 4-10: Keisuke Kageyama, "Synthesis and microwave dielectric characteristic of complex perovskite A $(B^{3+}{}_{1/2} B^{5+}{}_{1/2}) O_3$", Electronics-Ceramics, Sep. 1993, pp. 2160-2164);
(2) They provide insulating materials having a good lattice match with oxide superconductors ($YBa_2Cu_3O_x$; $NdBa_2Cu_3O_x$) (C. D. Brandle and V. J. Fratello, "Preparation of perovskite oxides for high Tc superconductor substrates", J. Master. Res., Vol. 5, No. 10, Oct. 1990, pp. 2160-2164).

When forming thin films through laser sputtering or high frequency sputtering, it is very difficult to accurately control the composition ratio of each metallic component included in the complex perovskite oxides, which are ternary compounds, each having different physical and chemical properties (actually, different mass and vapor pressure).

On the other hand, according to the prior art, when thin films are formed through metalorganic chemical vapor deposition, the amount of transportation of the three organic metal materials for growing the complex perovskite oxide is individually controlled, as disclosed for example in the following publication: B. Han., D. A. Neumayer, B. H. Goodreau and T. J. Marks, Chem. Mater., Vol. 6, 1994, pp. 18-20). However, it is very difficult to accurately control the amount of each material, considering the material temperature or the carrier gas flow and the like.

SUMMARY OF THE INVENTION

It is the underlying problem of the present invention to provide means for accurately controlling the two kinds of B-site elements having different physical and chemical properties to "$B^+$:$B^{5+}$ = 1:1", "$B^{3+}$:$B^{5+}$ = 1:1" and "$B^{2+}$:$B^{5+}$ = 1:2" compositions, in order to regulate and stabilize the properties (such as electrical and physical characteristics) of complex perovskite oxide ($A^{3+}{}_2 B + B^5 + O_6$, $A^{2+}{}_2 B^{3+} B^{5+} O_6$, $A^{2+}{}_3 B^{2+} B^{5+}{}_2 O_9$) thin films.

Thus it is the problem of the present invention to provide suitable compounds for accurately controlling the B-site element ratio, a method for preparing these compounds and their use for growing complex perovskite oxide thin films.

The above problem is solved according to the independent claims. The dependent claims relate to preferred embodiments of the concept of the present invention.

The invention provides BB'-type double metal alkoxides of the following formulae:

$$BB'(OR)_6, \qquad (I)$$

wherein: B is $B^+$, selected from Li, Na and K, and
B' is $T^{5+}$, selected from Nb and Ta;

$$BB'(OR)_8, \qquad (ii)$$

wherein: B is $B^{3+}$, selected from Al and Ga, and
B' is $B^{5+}$, selected from Nb and Ta;

$$B[B'(OR)_6]_2, \qquad (iii)$$

wherein:

B is $B^{2+}$, selected from Mg, Ca, Sr and Ba, and
B' is $T^{5+}$, selected from Nb and Ta,

R in formulae (i) to (iii) being a straight-chain or branched chain lower alkyl group comprising 1 to 6 carbon atoms and preferably 1 to 4 carbon atoms.

In the BB'-type double metal alkoxides according to the invention, R is preferably selected from methyl ($CH_3$), ethyl ($C_2H_5$), n-propyl (n-$C_3$-$H_7$), i-propyl (i-$C_3H_7$), n-butyl (n-$C_4H_9$), i-butyl (i-$C_4H_9$), t-butyl (t-$C_4H_9$), n-pentyl (n-$C_5H_{11}$), i-pentyl (i-$C_5H_{11}$, 3-methyl-1-butyl) and t-pentyl (t-pentyl, 2-dimethyl-1-propyl).

Particularly preferred BB'-type double metal alkoxides are those wherein R is selected from $CH_3$, $C_2H_5$, i-$C_3H_7$ and t-$C_4H_9$.

The BB'-type double metal alkoxides of the invention comprise

(i) $LiNb(OR)_6$, $LiTa(OR)_6$, $NaNb(OR)_6$, $NaTa(OR)_6$, $KNb(OR)_6$ and $KTa(OR)_6$;
(ii) $AlNb(OR)_8$, $AlTa(OR)_8$, $GaNb(OR)_8$ and $GaTa(OR)_8$;
(iii) $Mg(Nb(OR)_6]_2$, $Mg[Ta(OR)_6]_2$, $Ca[Nb(OR)_6]_2$, $Ca[Ta(OR)_6]_2$, $Sr[Nb(OR)_6]_2$, $Sr[Ta(OR)_6]_2$, $Ba[Nb(OR)_6]_2$ and $Ba[Ta(OR)_6]_2$.

Particularly preferred BB'-tpye double metal alkoxides are $AlTA(O-i-C_3H_7)_8$ and $AlTa(O-t-C_4H_9)$.

The method for preparing the BB'-type double metal alkoxides according to the invention is characterized by the following reactions in an inert solvent:

$$BOR + B'(OR)_5 \rightarrow BB'(OR)_6; \qquad (i)$$

$$B(OR)_3 + B'(OR)_5 \rightarrow BB'(OR)_8; \qquad (ii)$$

$$B(OR)_2 + 2\ B'(OR)_5 \rightarrow B[B'(OR)_6]_2, \qquad (iii)$$

B,B' and R being defined as in claim 1, wherein the reactants are used in a molar ratio of about or exactly 1:1 for reactions (i) and (ii) and 1:2 for reaction (iii), and subsequent isolation of the reaction products.

In this method an alcoholic solvent may be used as inert solvent, preferably isopropanol.

The reactions are preferably carried out under reflux of the reaction system, and the products are isolated by vacuum distillation.

The invention further relates to the use of the BB'-type double metal alkoxides as defined above for metalorganic chemical vapor deposition of complex perovskite oxide thin films.

This method for growing complex perovskite oxide thin films having plural metallic elements included in the B sites of a perovskite structure $ABO_3$ is characterized by metalorganic chemical vapor deposition of a BB'-type double metal alkoxide according to the invention.

Preferably, thin films comprising $A_2^{3+} B^+ B^{5+}O_6$, $A_2^{2+} B^{3+}B^{5+}O_6$, and/or $A_3^{2+} B^{2+}B_2^{5+} O_9$ are grown.

The present invention provides a metalorganic chemical vapor deposition method utilizing a BB'-type double metal alkoxide as material that will vaporize in the form of molecules including the two metallic elements (B and B').

BRIEF DESCRIPTION OF THE DRAWINGS

Fig. 1 shows the results of thermogravimetric analysis (TG) and differential thermal analysis (DTA) carried out on $TaAl(O-i-C_3H_7)_8$, confirming that the material has volatility within an appropriate temperature region;

Fig. 2 shows the mass spectrum measured by vaporizing the material $TaAl(O-i-C_3H_7)_8$ at 70 °C, and ionizing the same by 70 eV;

Fig. 3 shows an X-ray diffraction pattern of a thin film formed on an $SrTiO_3(100)(STO)$ single crystal substrate using $Sr(DPM)_2$-2-tetraen $(Sr(C_{11}H_{19}O_2)_2$, DPM designating dipivaloylmethanate) as one component, wherein the material supply conditions of $Sr(DPM)_2$-2-tetraen are 120 °C/500 ml, $TaAl(O-i-C_3H_7)_8$ 95 °C/1 ml, with a response pressure of 10 Torr, an oxygen partial pressure of 1 Torr, and the temperature of the substrate seat set to 850 °C;

Fig. 4 shows an X-ray diffraction pattern of a thin film formed on an MgO substrate under the same conditions as according to Fig. 3 but with a different lattice constant and a different crystal form, and

Fig. 5 shows a layered structure comprising a SAT thin film 1 and an oxide superconductor $NdBa_2Cu_3O_x$ 2 having good lattice match formed on a substrate 3, with electrodes 10 and 11 mounted thereto.

DETAILED DESCRIPTION OF PREFERRED EMBODIMENTS

Preparation of $TaAl(O-i-C_3H_7)_8$:

Equimolar amounts of $Ta(O-i-C_3H_7)_5$ and $Al(O-i-C_3H_7)_3$ are refluxed in an isopropanol solution, in order to synthesize $TaAl(O-i-C_3H_7)_8$, based on the method disclosed in the following documents: D. C. Bradley, R. C. Mehnotra and D. P. Gaur, "Metal Alkoxides", Academic Press, 1978, R. C. Mehnotra; Adv. Inorg. Chem. & Radiochem., Vol. 26, 1983, pp. 325-326; S. Govil, P. N. Kapoor and R. C. Mehnotra, Inorg. Chem. Acta., Vol. 15, 1975, pp. 43-46.

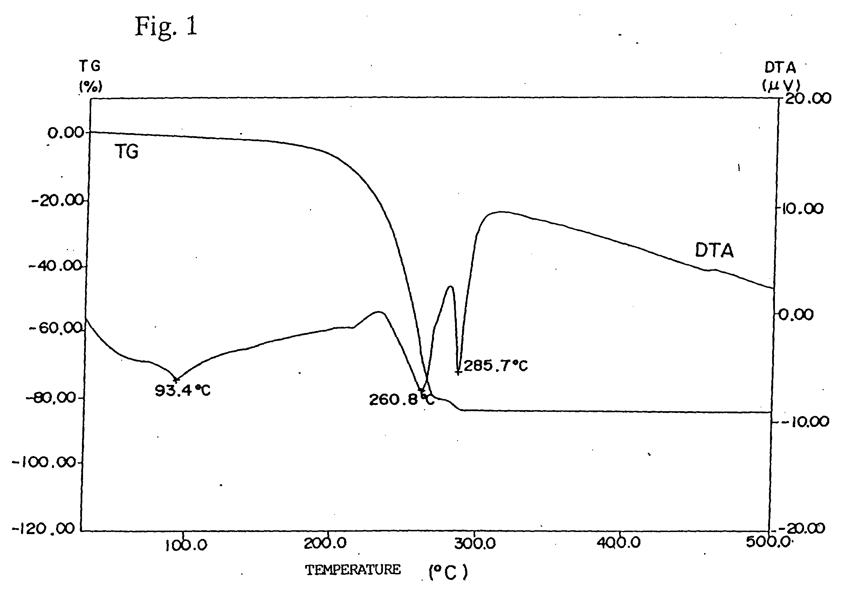

Fig. 1 shows the results of tests confirming through thermogravimetric analysis (TG) and differential thermal analysis (DTA) that the $TaAl(O-i-C_3H_7)_8$ materials shows volatility within an appropriate temperature region. The TG curve shows the decrease in weight through vaporization, which is gentle around room temperature and above, and steep in the range between 160 and 260 °C. Further, the DTA curve shows three endothermic reactions (93.4 °C, 260.8 °C, 285.7 °C) which are melting, vaporization and decomposition reaction, respectively. In other words, the graph shows that the material could be utilized for metalorganic chemical vapor deposition, in which the material is supplied through a desired vapor pressure ranging between room temperature and 260 °C, and is decomposed at or over 285 °C, thereby performing metal deposition.

Two methods are used to confirm the fact that the synthesized $TaAl(O-i-C_3H_7)_8$ material is transported in the vapor phase having a molecular form as disclosed.

The material is distilled and refined under the conditions of 130-135 °C/0.5 Torr, and the composition of the recovered product is analyzed through inductively coupled plasma atomic emission spectometry. The metallic composition is Ta 26.4 wt% (theoretical value 26.59 wt%), Al 3.92 wt% (theoretical value 3.96 wt%), and the Ta/Al molar ratio is computed as 1.004. The results show that the vapor-phase material was transported in the molecular form of $TaAl(O-i-C_3H_7)_8$.

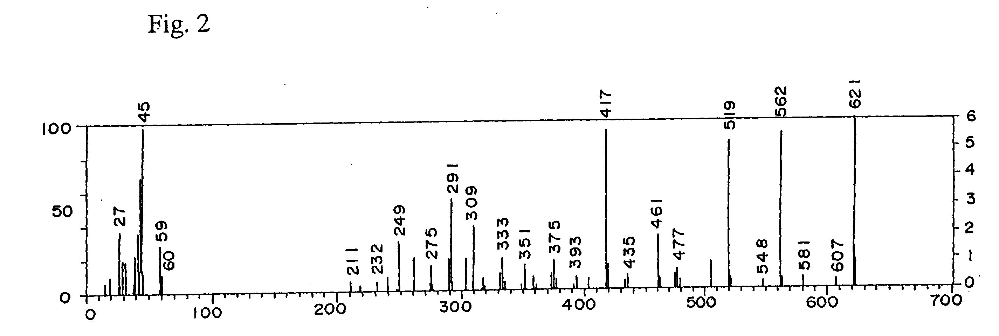

The mass of the vapor-phase molecules is analyzed through mass spectometry. Fig. 2 shows the mass spectrum measured by vaporizing the material at 70 °C, and ionizing the same at 70 eV. The main fragments m/e are 621, 562 and 519 on the high mass side and correspond to $TaAl(O-i-C_3H_7)_7^+$, $TaAl(O-i-C_3H_7)_6^+$, and $TaAlO(O-i-C_3H_7)_5^+$, respectively. It shows that the material vapor is existing in the form of molecules including both metals Ta and Al.

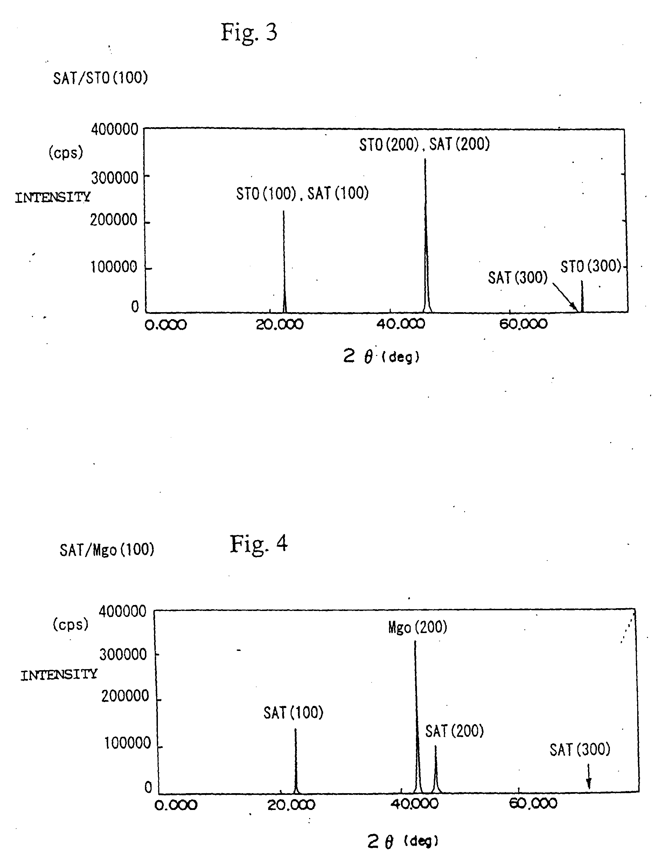

An $Sr_2AlTaO_6$ (SAT) thin film, which is one of the complex perovskite oxides, is formed through a binary metalorganic chemical vapor deposition utilizing $Sr(DPM)_2$-2-tetraen and $TaAl(O-i-C_3H_7)_8$ as materials; Fig. 3 shows the X-ray diffraction pattern of a thin film formed on an $SrTiO_3(100)$(STO) single crystal substrate, wherein the material supply conditions for $Sr(DPM)_2$-2-tetraen are 120 °C/500 ml and for $TaAl(O-i-C_3H_7)_8$ are 95 °C/1 ml, the reaction pressure is 10 Torr, the oxygen partial pressure is 1 Torr, and the substrate seat temperature is 850 °C.

Only a slight diffraction peak of SAT (300) is observed on the left side of the STO (300) peak, but as confirmed on bulk SAT (C. D. Brandle and V. J. Fratello, "Preparation of perovskite oxides for high Tc superconductor substrates", J. Mater. Res., Vol. 5, No. 10, Oct. 1990, pp. 2160-2164), it shows substantially the same lattice constant as the STO of the substrate material. No other impurity phase is observed.

Fig. 4 shows the X-ray diffraction pattern of a thin film formed on an MgO substrate under the same conditions as Fig. 3, but with a different lattice constant and different crystal form. According to the pattern of Fig. 4, the three diffraction peaks of SAT(100), (200) and (300) are observed clearly, with no other impurity phase observed. Both show that a single phase SAT thin film is formed by the metalorganic chemical vapor deposition according to the present method.

According to the analysis of the composition of the prepared thin film through an energy dispersion X-ray analysis, the content ratio of Ta and Al within the thin film is approximately Ta:Al = 1:1.03. Considering analysis errors, the ratio of Ta and Al contained in the thin film is substantially 1:1.

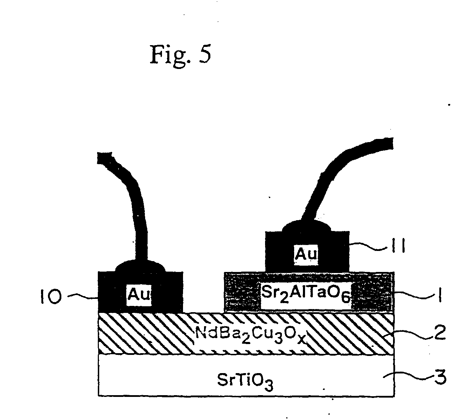

As shown in Fig. 5, a layered structure of a SAT thin film 1 and an oxide superconductor $NdBa_2Cu_3O_x$ 2 having good lattice match is formed on a substrate 3. Electrodes 10 and 11 are fixed on the layered structure to measure the insulating properties and the dielectric properties of the layered structure, and the results showed an insulation resistance of $\rho = 100$ $M\Omega \cdot cm$ or more, and a relative dielectric constant of $\varepsilon_0 = 25$ or less. The results show that a SAT thin film having good insulating properties and good dielectric properties is obtained according to the present metalorganic chemical vapor deposition.

Though it is very difficult to form a complex perovskite oxide thin film while maintaining good control of its composition, it is necessary to adjust especially the "$B^+$:$B^{5+}$", "$B^{3+}$:$B^{5+}$", and "$B^{2+}$:$B^{5+}$" composition ratios to a fully stoichiometric ratio of "1:1" or "1:2", in order to obtain good properties and to further control the properties more accurately. The present method utilizes BB'-type double metal alkoxides as materials, and provides a composition adjustment function inherent to the material itself. As a result, there is no need to adjust the composition according to the deposition conditions (which is the case with other methods), and the present invention enables to provide a process in which the stoichiometric composition is achieved automatically under any condition.

**Claims**

1. BB'-type double metal alkoxides of the following formulae:

$$BB'(OR)_6, \qquad (i)$$

wherein: B is $B^+$, selected from Li, Na and K, and
B' is $T^{5+}$, selected from Nb and Ta;

$$BB'(OR)_8, \qquad (ii)$$

wherein: B is $B^{3+}$, selected from Al and Ga, and
B' is $B^{5+}$, selected from Nb and Ta;

$$B[B'(OR)_6]_2, \qquad (iii)$$

wherein:

B is $B^{2+}$, selected from Mg, Ca, Sr and Ba, and
B' is $T^{5+}$, selected from Nb and Ta,

R in formulae (i) to (iii) being a straight-chain or branched chain lower alkyl group comprising 1 to 6 carbon atoms and preferably 1 to 4 carbon atoms.

2. BB'-type double metal alkoxides according to claim 1, wherein R is selected from methyl ($CH_3$), ethyl

$(C_2H_5)$, n-propyl (n-$C_3$-$H_7$), i-propyl (i-$C_3H_7$), n-butyl (n-$C_4H_9$), i-butyl (i-$C_4H_9$), t-butyl (t-$C_4H_9$), n-pentyl (n-$C_5H_{11}$), i-pentyl (i-$C_5H_{11}$, 3-methyl-1-butyl) and t-pentyl (t-pentyl, 2-dimethyl-1-propyl).

**3.** BB'-type double metal alkoxides according to claim 1 or 2, R being selected from $CH_3$, $C_2H_5$, i-$C_3H_7$ and t-$C_4H_9$.

**4.** BB'-type double metal alkoxides according to any of claims 1 to 3, selected from

(i) $LiNb(OR)_6$, $LiTa(OR)_6$, $NaNb(OR)_6$, $NaTa(OR)_6$, $KNb(OR)_6$ and $KTa(OR)_6$;
(ii) $AlNb(OR)_8$, $AlTa(OR)_8$, $GaNb(OR)_8$ and $GaTa(OR)_8$;
(iii) $Mg(Nb(OR)_6)_2$, $Mg[Ta(OR)_6]_2$, $Ca[Nb(OR)_6]_2$, $Ca[Ta(OR)_6]_2$, $Sr[Nb(OR)_6]_2$, $Sr[Ta(OR)_6]_2$, $Ba[Nb(OR)_6]_2$ and $Ba[Ta(OR)_6]_2$.

**5.** BB'-type double metal alkoxides according to any of claims 1 to 4, selected from $AlTa(O-i-C_3H_7)_8$ and $AlTa(O-t-C_4H_9)$.

**6.** Method for preparing the BB'-type double metal alkoxides according to claims 1 to 5, characterized by the following reactions in an inert solvent:

$$BOR + B'(OR)_5 \rightarrow BB'(OR)_6; \qquad (i)$$

$$chB(OR)_3 + B'(OR)_5 \rightarrow BB'(OR)_8; \qquad (ii)$$

$$B(OR)_2 + 2\,B'(OR)_5 \rightarrow B[B'(OR)_6]_2, \qquad (iii)$$

B,B' and R being defined as in claim 1, wherein the reactants are used in a molar ratio of about or exactly 1:1 for reactions (i) and (ii) and 1:2 for reaction (iii), and subsequent isolation of the reaction products.

**7.** Method according to claim 6, wherein an alcoholic solvent, preferably isopropanol, is used as inert solvent.

**8.** Method according to claim 6 or 7, wherein the reactions are carried out under reflux of the reaction system, and the products are isolated by vacuum distillation.

**9.** Use of the BB'-type double metal alkoxides according to any of claims 1 to 5 for metalorganic chemical vapor deposition of complex perovskite oxide thin films.

**10.** Method for growing complex perovskite oxide thin films having plural metallic elements included in the B sites of a perovskite structure $ABO_3$, characterized by metalorganic chemical vapor deposition of a BB'-type double metal alkoxide according to any of claims 1 to 5.

**11.** Method according to claim 10, characterized in that thin films comprising $A^{3+}_2 B^+B^{5+}O_6$, $A^{2+}_2 B^{3+}B^{5+}O_6$, and/or $A^{2+}_3 B^{2+}B^{5+}_2 O_9$ are grown.

Fig. 1

TG
(%)

DTA
(μV)

TEMPERATURE (°C)

EP 1 081 154 A2

Fig. 2

Fig. 3

SAT/STO (100)

Fig. 4

SAT/Mgo (100)

Fig. 5